# EUROPEAN PATENT SPECIFICATION

(11) **EP 1 826 774 B1**
(45) Date of publication and mention of the grant of the patent: **26.08.2009**
(21) Application number: 07102158.8
(22) Date of filing: 12.02.2007
(51) Int. Cl.: G11C 11/16

(54) **Magnetic memory device using magnetic domain motion**
Magnetspeichervorrichtung unter Verwendung der Bewegung magnetischer Domänen
Dispositif de mémoire magnétique utilisant un mouvement de domaine magnétique

(30) Priority: 23.02.2006 KR 20060017875
(43) Date of publication of application: 29.08.2007
(73) Proprietor: Samsung Electronics Co., Ltd., Suwon-si, Gyeonggi-Do (KR)
(72) Inventor: Kim, Kee-won, c/o Samsung Advanced Institute of Technology, Yongin-si, Gyeonggi-do (KR); Kim, Tae-wan, c/o Samsung Advanced Institute of Technology, Yongin-si ,Gyeonggi-do (KR); Cho, Young-jin, c/o Samsung Advanced Institute of Technology, Yongin-si, Gyeonggi-do (KR); Hwang, In-jun, c/o Samsung Advanced Insitute of Technology, Yongin-si, Gyeonggi-do (KR)
(74) Representative: Greene, Simon Kenneth

(56) References cited:
- EP-A- 1 320 102
- US-A1- 2004 251 232
- US-A1- 2004 257 719

## Description

### BACKGROUND OF THE INVENTION

The present invention relates to a magnetic memory, and more particularly, to a magnetic memory where data bits each represented by magnetic domains can be stored in an array and that uses a magnetic domain motion.

Magnetic random access memories (MRAM) are a kind of non-volatile magnetic memories. MRAM is a new kind of solid state magnetic memory that uses a magnetic resistance effect based on spin-dependent conduction characteristic of a nano magnetic material. That is, MRAMs use giant magnetoresistance (GMR) or tunnel magnetoresistance (TMR) generated as spin, which is a degree of freedom of an electron, has a great influence on electron delivery.

GMR is a resistance difference generated when a non-magnetic material is interposed between ferromagnetic materials having the same magnetization direction or different magnetization directions in an adjoining arrangement of ferromagnetic material/metallic non-magnetic material/ferromagnetic material. TMR is resistance where a current easily flows when two ferromagnetic materials have the same magnetization direction in an adjoining arrangement of ferromagnetic material/insulator/ferromagnetic material compared to when the two ferromagnetic materials have different magnetization directions. Since MRAMs using GMR have a relatively small resistance difference caused by magnetization direction, a large voltage difference cannot be achieved. Also, since MRAMs have a disadvantage that the size of a metal oxide semiconductor field effect transistor (MOSFET) that is combined with a GMR layer in order to form a cell is large, research for pursuing commercialization of MRAMs using a TMR layer is currently being carried out more actively.

An MRAM may consist of a transistor, which is a switching device, and a magnetic tunnel junction (MTJ) cell in which data is stored. Generally, the MTJ cell may consist of a pinned ferromagnetic layer having a pinned magnetization direction, a free ferromagnetic layer having a magnetization direction which may be parallel or anti-parallel to the magnetization direction of the pinned ferromagnetic layer, and a non-magnetic layer interposed between the pinned ferromagnetic layer and the free ferromagnetic layer, and magnetically separating the ferromagnetic layers.

However, since a general MRAM only stores one-bit of data per MTJ cell, there are limitations in data storage capacity of MRAMs. Therefore, a new storage technology is required in order to increase an information storage capacity of magnetic memories such as MRAMs.

US 2004/0251232 describes a shiftable MRAM with a magnetic data track, a reading device and a writing device. The track is shifted to bring a desired magnetic domain to the reading or writing device as required.

EP 1320102 describes another MRAM using magnetic domain drag.

US 2004/0257719 describes an MRAM cell.

### SUMMARY OF THE INVENTION

The present invention provides a magnetic memory device having a plurality of memory tracks each having a plurality of magnetic domains formed thereon so that data bits can be stored in an array thereon, and each using magnetic domain motion, and forming the memory tracks in a multi-stacked structure, thereby remarkably increasing data storage capacity.

According to an aspect of the present invention, there is provided a magnetic memory device according to claim 1.

The connector may include a reference layer formed to correspond to a portion of the memory track and having a pinned magnetization direction, wherein a data bit corresponding to an effective size of the reference layer is stored in an array on the memory track.

The connector may further include a non-magnetic layer located between the reference layer and the memory track.

The non-magnetic layer may be a conduction layer or an insulation layer serving as a tunneling barrier.

The selecting part may include: a plurality of impurity regions respectively connected to data bit regions constituting MTJ cells of the memory tracks; and a gate formed between two impurity regions, wherein the selecting part has a structure of a sharing transistor, wherein at least one impurity region serves as a drain for a predetermined memory track and serves as a source for other memory track, and each of the impurity regions is connected to the data bit region constituting the MTJ of each memory track via a conductive plug.

Each memory track may include: a data storage region having data bit regions corresponding to the number of data bits to be stored and storing a plurality of data bits; and a buffer region that adjoins the data storage region and storing, if necessary, data moved to the outside of the data storage region during a magnetic domain motion.

Each memory track may include a plurality of data storage regions, wherein the buffer region is located between two adjoining data storage regions, and the connector and the selecting parts are formed to correspond to the respective plurality of data storage regions formed on each memory track.

The memory device may further include a second input portion inputting at least one of a writing current signal and a reading current signal to the MTJ cell through the bit line.

### BRIEF DESCRIPTION OF THE DRAWINGS

The above and other features and advantages of the present invention will become more apparent by describing in detail exemplary embodiments thereof with reference to the attached drawings in which:
FIG. 1 is a schematic view illustrating the structure of a magnetic memory device having multi-stacked memory tracks according to an embodiment of the present invention;
FIGS. 2A through 2C are views illustrating operational states when writing or reading operations are performed on first to third memory tracks of the magnetic memory device of FIG. 1;
FIGS. 3A through 3C are views illustrating a data writing operation performed on a selected memory track of a magnetic memory device according to an embodiment of the present invention;
FIGS. 4A and 4B are views illustrating a stored data reading operation performed on a selected memory track of a magnetic memory device according to an embodiment of the present; and
FIG. 5 is a schematic graph illustrating a magnetic domain motion current signal: Pulse(motion), a reading pulse signal current: Pulse 2(reading) and a writing switching current signal : Pulse2(writing) that are applied to a magnetic memory device according to an embodiment of the present invention.

### DETAILED DESCRIPTION OF THE INVENTION

The present invention will now be described more fully with reference to the accompanying drawings, in which exemplary embodiments of the invention are shown.

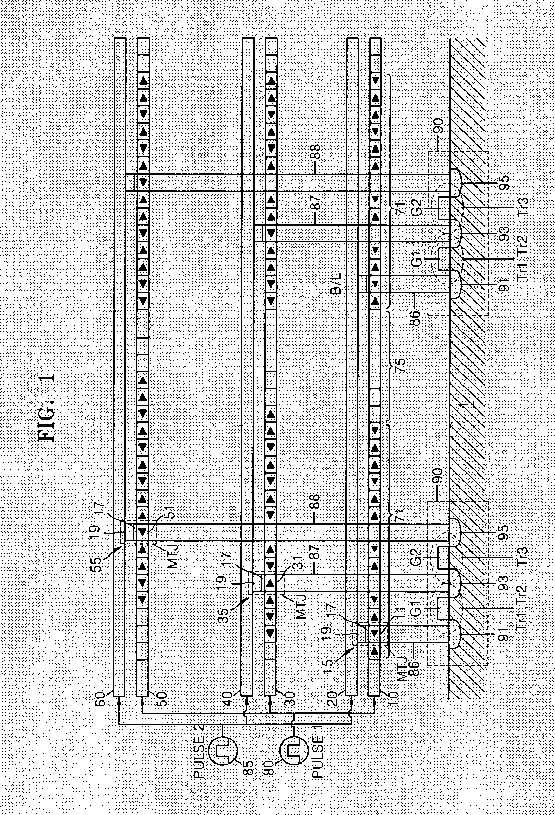

FIG. 1 is a schematic view illustrating the structure of a magnetic memory device having multi-stacked memory tracks according to an embodiment of the present invention. Referring to FIG. 1, a Pulse 1 is a magnetic domain motion signal, and a Pulse 2 is one of a reading signal and a writing signal.

Referring to FIG. 1, the magnetic memory device includes: first to third memory tracks 10, 30, and 50 stacked to form a multi-stacked memory on a substrate; first to third bit lines 20, 40, and 60 formed close to the first to third memory tracks 10, 30, and 50, respectively; first to third connecting parts 15, 35, and 55 respectively formed between the first to third memory tracks 10, 30, and 50 and the first to third bit lines 20, 40, and 60; a first input portion 80 electrically connected to the first to third memory tracks 10, 30, and 50 and inputting a magnetic domain motion signal; and a selecting part 90 selecting a memory track from the first to third memory tracks 10, 30, and 50 on which a reading or writing operation is to be performed.

In the magnetic memory device as illustrated in FIG. 1, the selecting part 90 is formed in the substrate 1, and the first memory track 10, the first bit line 20, the second memory track 30, the second bit line 40, the third memory track 50, and the third bit line 60 may be sequentially stacked on the selecting part 90. Insulation layers may be interposed between layers of the above-mentioned elements. Empty spaces between the elements in FIG. 1 are insulation layers. Since this layered structure may be manufactured in various methods, description of the methods of manufacturing this layered structure will be omitted.

The first to third memory tracks 10, 30, and 50 are recording layers and are formed to have one of an in-plane magnetization direction and a vertical magnetization direction and to be switched magnetization direction. Each of the first to third memory tracks 10, 30, and 50 may have a plurality of magnetic domains, so that a data bit consisting of one magnetic domain may be stored in an array of data bits. Here, each of the first to third memory tracks 10, 30, and 50 may have a plurality of magnetic domain walls by which the plurality of magnetic domains are formed.

The first to third connectors 15, 35, and 55 are respectively formed between the first to third memory tracks and the first to third bit lines to form magnetic tunnel junction (MTJ) cells together with data bit regions 11, 31, and 51 of the first to third memory tracks 10, 30, and 50. One end of each of the first to third connectors 15, 35, and 55 contacts the first to third bit lines 20, 40, and 60, respectively. The other end of each of the first to third connectors 15, 35, and 55 contacts portions of the first to third memory stacks 10, 30, and 50 (i.e., predetermined data bit regions 11, 31, and 51 that constitute the MTJ cells), respectively.

To form the MTJ cells, each of the first to third connectors 15, 35, and 55 has a reference layer 19 formed to correspond to a portion of each of the first to third memory tracks 10, 30, and 50 and having a pinned magnetization direction. The reference layer 19 may have one of a pinned in-plane magnetization direction and a pined perpendicular magnetization direction. Each of the first to third connectors 15, 35, and 55 may further include a non-magnetic layer 17 located between the reference layer 19 and the each of the first to third memory tracks 10, 30, and 50. This non-magnetic layer 17 may be one of a conduction layer such as Cu and an insulation layer such as an aluminum oxide layer serving as a tunneling barrier.

Here, each of the first to third memory tracks 10, 30, and 50 has a switchable magnetization direction, and the reference layer 19 has a pinned magnetization direction. For that purpose, the reference layer 19 may be formed having a multi-layered thin film structure made of antiferromagnetic materials such as IrMn and PtMn. As another example, when each of the first to third memory tracks 10, 30, and 50 and the reference layer 19 are formed of the same material, the first to third memory stacks may be formed to have relatively small coercive forces, and the reference layer 19 may be formed to have relatively large coercive force. The coercive force may be controlled by changing a composition ratio of elements of materials used for forming the first to third memory tracks 10, 30, and 50, and the reference layer 19.

Each data bit region consisting of a magnetic domain formed in each of the first to third memory tracks 10, 30, and 50 represents 1-bit of data. Each data bit region may have a size that corresponds to an effective size of the reference layer 19 of each of the first to third connectors 15, 35, and 55. Accordingly, the data bit consisting of a magnetic domain that has a size corresponding to the effective size of the reference layer 19 may be stored in an array on the first to third memory tracks 10, 30, and 50. Here, the data bit region representing 1-bit of data may consist of a single magnetic domain.

In the magnetic memory device according to the present invention, a data writing operation or a stored data reading operation may be performed by an area unit of each of the first to third memory tracks 10, 30, and 50 which corresponds to the effective size of the reference layer 19. Therefore, the effective area of the reference layer 19 substantially determines a size of one data bit region (i.e., a magnetic domain) of each of the first to third memory tracks 10, 30, and 50.

Since it is preferable that only a single magnetic domain exists within one data bit region, magnetic domains formed in each of the first to third memory tracks 10, 30, and 50 may be formed to have size that at least corresponds to an effective size of the reference layer 19.

Also, each of the first to third memory tracks 10, 30, and 50 may be formed to have a length long much as a multiple of the number of data bit regions that each has a size corresponding to an effective size of the reference layer 19, that is, a width of a magnetic domain motion direction. Accordingly, an array of a plurality of data bit regions each region consisting of a single magnetic domain in an unit of effective size of the reference layer 19 are formed, so that a plurality of data bits can be stored in an array on each of the first to third memory tracks 10, 30, and 50.

Referring to FIG. 1, each of the first to third memory tracks 10, 30, and 50 includes: a data storage region 71 having a number of data bit regions corresponding to a number of data bits to be stored, and storing a plurality of data bits; and a buffer region 75 adjoining the data storage region 71 and temporarily storing data moved outside of the data storage region 71 during a magnetic domain motion. The buffer region 75 may be located on at least one side of the data storage region 71. Here, each of the first to third memory tracks 10, 30, and 50 may not be divided into data storage regions and buffer regions.

Also, in to the magnetic memory device according to the current embodiment of the present invention, each of the first to third memory tracks 10, 30, and 50 may include a plurality of data storage regions 71. A buffer region 75 may be interposed between consecutive data storage regions 71. At this point, the first to third connectors 15, 35, and 55, and the selecting part 90 may be located to respectively correspond to the plurality of data storage regions 71 formed in the first to third memory tracks 10, 30, and 50 as illustrated in FIG. 1.

The selecting part 90 is intended for selecting a memory track from the first to third memory tracks 10, 30, and 50 on which a reading or writing operation is to be performed. The selecting part 90 includes: first to third impurity regions 91, 93, and 95 each being connected to the data bit regions 11, 31, and 51 constituting the MTJ cells of the first to third memory tracks 10, 30, and 50; and a first gate G1 and a second gate G2 (word lines) respectively formed between the first and second impurity regions 91 and 93, and between the second and third impurity regions 93 and 95. The selecting part 90 may have a structure of a shared transistor such that at least one of the impurity regions serves as a drain for a predetermined memory track and the other one of the impurity regions serves as a source for another predetermined memory track.

For example, the first impurity region 91, the first gate G1, and the second impurity region 93 may serve as transistors Tr1 and Tr2 for the first and second memory tracks 10 and 30. On the other hand, the second impurity region 93, the second gate G2, and the third impurity region 95 may serve as a transistor Tr3 for the third memory track 50. In this way, the first impurity region 91 serves as a source, and the second impurity region 93 serves as a drain for the first memory track 10. Also, the first impurity region 91 serves as a drain and the second impurity region 93 serves as a source for the second memory track 30. Similarly, the second impurity region 93 serves as a drain and the third impurity region 95 serves as a source for the third memory track 50.

In another arrangement, the first impurity region 91, the first gate G1, and the second impurity region 93 may serve as a transistor Tr1 for the first memory track 10. In addition, the second impurity region 93, the second gate G2, and the third impurity region 95 may serve as transistors Tr2 and Tr3 for the second and third memory tracks 30 and 50.

Here, the substrate 1 may be a semiconductor substrate. The first and second gates G1 and G2 each having a layered structure that includes a gate insulation layer and a gate electrode are formed on the substrate 1, and a portion between the first and second gates G1 and G2, and portions of the substrate 1 located beside of the first and second gates G1 and G2 are doped with impurities to form the first to third impurity regions 91, 93, and 95 serving as sources and drains, so that the shared transistor structure is formed. After the selecting part 90 having the shared transistor structure is formed on the substrate, a stacked structure where the first memory track 10, the first connector 15, the first bit line 20, the second memory track 30, the second connector 35, the second bit line 40, the third memory track 50, the third connector 55, and the third bit line 60 are sequentially stacked, is formed. Of course, as described above, the first to third memory tracks 10, 30, and 50, the first to third connectors 15, 35, and 55, and the first to third bit lines 20, 40, and 60, excluding portions for connecting with and electrical connection with other elements, are surrounded by insulation materials. Insulation layers may be formed between layers.

The first to third impurity regions 91, 93, and 95 are electrically connected to predetermined data bit regions 11, 31, and 51 constituting the MTJ cells of the first to third memory tracks 10, 30, and 50 via conductive plugs 86, 87, and 88, respectively. One end of each of the conductive plugs 86, 87, and 88 contacts the first to third impurity regions 91, 93, and 95, respectively. The other ends of each of the conductive plugs 86, 87, and 88 contact predetermined data bit regions 11, 31, and 51 constituting the MTJ cells of the first to third memory tracks 10, 30, and 50.

Since the selecting part 90 is formed to have the shared transistor structure, the structure of the selecting part 90 may be simplified when compared to a case where transistors are formed for each of the first to third memory tracks 10, 30, and 50, respectively. That is, when the transistors are formed for the first to third memory tracks 10, 30, and 50, respectively, three gates and six impurity regions are required. On the other hand, when the shared transistor structure is used, it is possible to perform an operation of selecting one of the first to third memory tracks 10, 30, and 50 with only two gates and three impurity regions.

On the other hand, the first input portion 80 is electrically connected to the first to third memory tracks 10, 30, and 50 in order to move a magnetic domain of the first to third memory tracks 10, 30, and 50 and thus move data (i.e., stored in an in-plane magnetization or a perpendicular magnetization) stored in a data bit region to an adjoining data bit region. Switches (not shown) may be further provided between the first input portion 80 and the first to third memory tracks 10, 30, and 50 so that a magnetic domain motion signal is input to only a selected predetermined memory track.

A magnetic domain motion signal (Pulse 1) is applied to the first to third memory tracks 10, 30, and 50 through the first input portion 80. A magnetization direction of a magnetic domain is moved to an adjoining magnetic domain according to the magnetic domain motion signal, i.e., a motion current signal input through the first input portion 80. Such motion is called a magnetic domain motion.

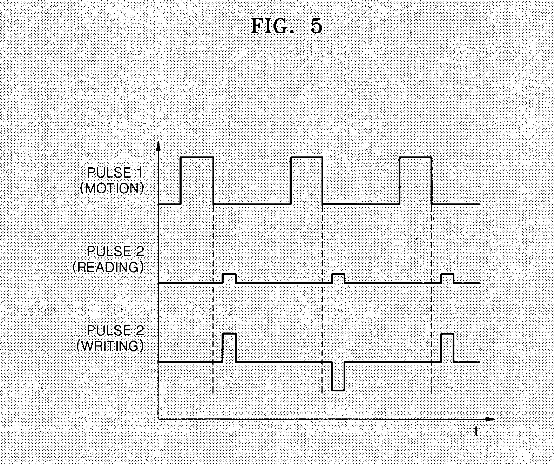

The magnetic domain motion signal may be a current signal of a pulse having a predetermined period as illustrated in FIG. 5. The magnetic domain motion signal may be input such that the magnetic domain motion is performed by a data bit region unit that includes a single magnetic domain. Here, since the magnetic domain motion is to substantially move a magnetization direction of a predetermined magnetic domain to an adjoining magnetic domain, the motion signal may be maintained while the magnetic domain motion is performed by a data bit region unit, and periodically applied such that the magnetic domain motion is performed by a data bit region unit.

In addition, the magnetic memory device according to the current embodiment of the present invention may be constituted so that at least one of a data writing operation and a data reading operation, and preferably, both a data writing operation and a data reading operation may be performed by applying a current.

For this purpose, the magnetic memory device may further include a second input portion 85 inputting at least one of a writing current signal and a reading current signal to the MTJ cell via the first to third bit lines 20, 40, and 60. The magnetic memory device according to the present invention does not require an electrode pad in comparison to a general magnetic memory device which applies a magnetic field to an MTJ cell using an electrode pad in order to perform a writing operation. In the magnetic memory device according to the present invention, the connectors 15, 35, and 55, predetermined data bit regions 11, 31, and 51 of the memory tracks 10, 30, and 50 constituting the MTJ cells, and the conductive plugs 86, 87, and 88 respectively connecting the predetermined data bit regions 11, 31, and 51 with the impurity regions 91, 93, and 95 of the selecting part 90 can be arranged in a line, so that a structure of the magnetic memory device may be simplified even more.

The magnetic memory device according to the present invention allowing a data writing operation and a data reading operation performed by applying current will be described below as an example.

The second input portion 85 is electrically connected to the first through third bit lines 20, 40, and 60. Therefore, the second input portion 85 is electrically connected to the first to third memory tracks 10, 30, and 50 via the predetermined data bit regions 11, 31, and 51 of the first to third memory tracks 10, 30, and 50 and the reference layers 19 that constitute the MTJ cells.

Switches (not shown) may be further provided between the second input portion 85 and the first to third bit lines 20, 40, and 60 so that one of a writing signal and a reading signal is input to only a predetermined memory track selected through a selected bit line.

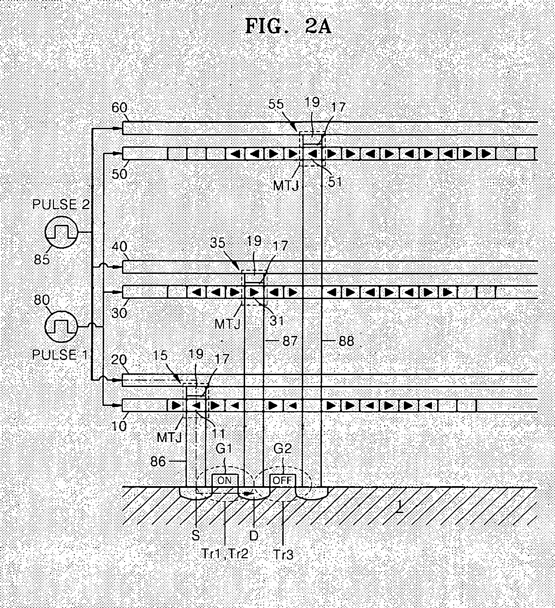

FIG. 2A is a diagram illustrating operational state when a writing operation or a reading operation is performed on the first memory track 10 of the magnetic memory device of FIG. 1. When a writing operation or a reading operation is performed on the first memory track 10, the first gate G1 is turned on, the second gate G2 is turned off, and a writing signal or a reading signal from the second input portion 85 is input to the first bit line 20. At this point, the first impurity region 91 serves as a source, and the second impurity region 93 serves as a drain.

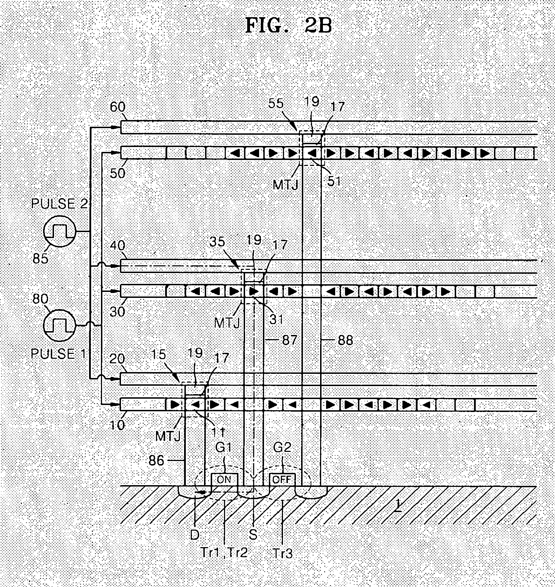

FIG. 2B is a diagram illustrating operational state when a writing operation or a reading operation is performed on the second memory track 30 of the magnetic memory device of FIG. 1. When a writing operation or a reading operation is performed on the second memory track 30, the first gate G1 is turned on, the second gate G2 is turned off, and a writing signal or a reading signal from the second input portion 85 is input to the second bit line 40. At this point, the first impurity region 91 serves as a drain, and the second impurity region 93 serves as a source.

Here, the second impurity region 93, the second gate G2, and the third impurity region 95 of the selecting part 90 can be used as a transistor for the second and third memory tracks 30 and 50, where the first gate G1 is turned off and the second gate G2 is turned on.

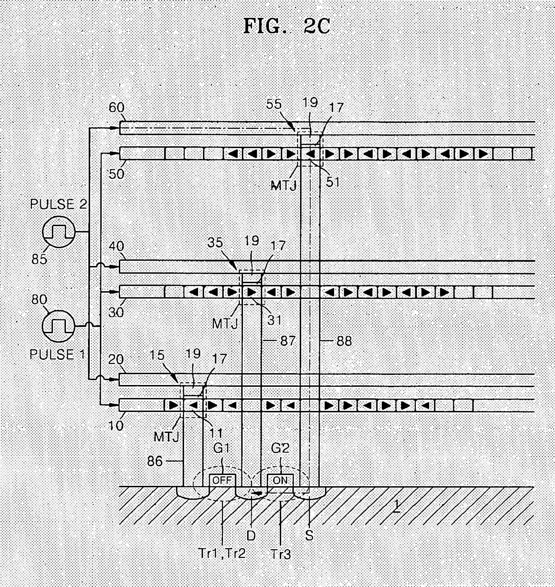

FIG. 2C is a diagram illustrating operational state when a writing operation or a reading operation is performed on the third memory track 50 of the magnetic memory device of FIG. 1. When a writing operation or a reading operation is performed on the third memory track 50, the first gate G1 is turned off, the second gate G2 is turned on, and one of a writing signal and a reading signal from the second input portion 85 is input to the third bit line 60. At this point, the second impurity region 93 serves as a drain, and the third impurity region 95 serves as a source.

A writing signal or a reading signal is input in synchronization with a magnetic domain motion signal.

In the magnetic memory device according to an embodiment of the present invention, continuing magnetic domains of a selected memory track are moved and a data bit, i.e., "0" or "1" is recorded on a predetermined data bit region (a magnetic domain located at a predetermined position corresponding to the reference layer 19) constituting an MTJ cell of a selected memory track according to a magnetic domain motion signal (Pulse 1) applied from the first input portion 80 to the selected memory track, and a writing current signal (e.g., Pulse 2 (writing) in FIG. 5) applied, in synchronization with this magnetic domain motion signal (Pulse 1), from the second input portion 85 to the predetermined data bit region constituting the MTJ cell of the selected memory track selected through a selected bit line. At this point, magnetization is selectively reversed using spin transfer torque, i.e., current induced magnetic switching (CIMS) according to a writing current signal, so that a data bit, i.e., "0" or "1" is recorded.

A writing signal is input from the second input portion 85 to a predetermined data bit region and reference layer 19 of a selected memory track through one bit line selected from the first to third bit lines 20, 40, and 60. A magnetization direction of a predetermined data bit region of the selected memory track that is located below the reference layer 19 is determined according to this writing signal.

A magnetization direction of the predetermined data bit region is determined according to a writing signal input from the second input portion 85. For example, when the predetermined data bit region has a predetermined magnetization direction, the magnetization direction of the predetermined data bit region is reversed or maintains an original magnetization direction depending on an applied writing signal. The magnetization direction determined in this manner represents a recorded data bit.

Referring to FIG. 5, the writing signal is a pulse-type switching current. A magnetization direction of a predetermined data bit region of a selected memory track is selectively switched depending on the polarity of the switching current, and a data bit, i.e., "0" or "1" is stored on the predetermined data bit region corresponding to the polarity of the switching signal.

For example, assuming that a data bit is determined as "0" when a magnetization direction of a predetermined data bit region becomes the same as, i.e., parallel to that of the reference layer 19 by application of a switching current, a data bit may be determined as "1" when the predetermined data bit region has a magnetization direction anti-parallel to that of the reference layer 19 by application of a switching current having an opposite polarity. Consequently, data is stored by changing the polarity of the switching current to allow the magnetization direction of the predetermined data bit region to be the same as that of the reference layer 19 or to be opposite to that of the reference layer 19.

Here, the magnetization direction of the reference layer 19 is determined in advance. Therefore, assuming that a data bit is "0" when the magnetization direction of the predetermined data bit region of the selected memory track is parallel to that of the magnetization direction of the reference layer 19 defined in advance, and a data bit is "1" when the magnetization direction of the predetermined data bit region is anti-parallel to that of the magnetization direction of the reference layer 19, desired data may be stored by switching the magnetization direction of the predetermined data bit region of the memory track.

According to the magnetic memory device of the present invention, a magnetic domain is moved, and data stored on a magnetic domain of a selected memory track is read using, for example, spin tunnelling according to a magnetic domain motion signal (Pulse 1) applied from the first input portion 80 to the selected memory track, and a reading current signal, e.g., a pulse type current signal for reading (Pulse 2 (reading) in FIG. 5) applied, in synchronization with the magnetic domain motion signal (Pulse 1), from the second input portion 85 to an MTJ cell (a predetermined data bit region and a reference layer 19) of the selected memory track through a selected bit line.

Data is read by measuring variation an intensity of a passing current or resistance of a predetermined data bit region depending on a magnetization direction of the predetermined data bit region of a selected memory track with respect to the magnetization direction of the reference layer 19..

Referring to FIG. 5, the reading pulse current may have smaller amplitude than the switching current for writing. The reading pulse current is applied in synchronization with the domain motion signal. Therefore, stored data may be read using a magnetic domain motion in reference to a magnetization direction of a predetermined data bit region located on the reference layer 19.

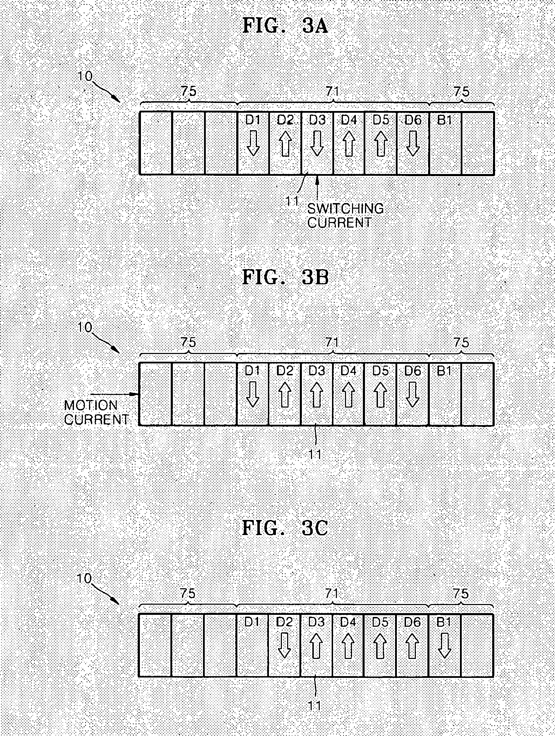

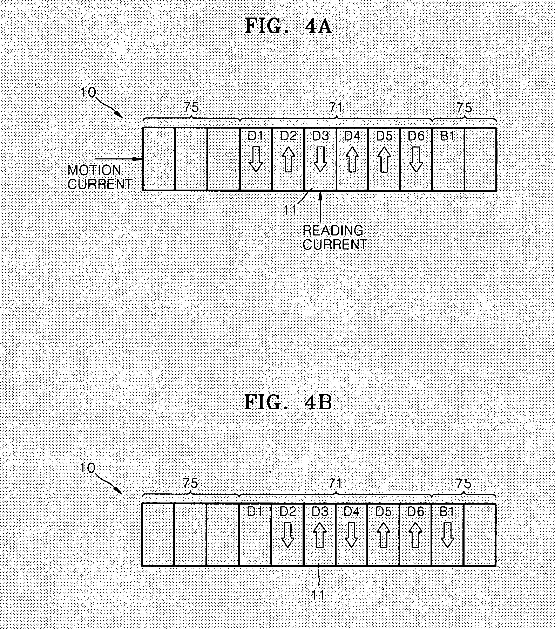

In the magnetic memory device having the above-described structure according to the present invention, the writing switching current or reading pulse current, and pulses of the input motion signal may be alternately inputted. Therefore, a data writing operation or stored data reading operation, and a magnetic domain motion can be alternately performed, so that a plurality of data bits are sequentially recorded on a plurality of data bit regions, or a plurality of data bits stored on the plurality of data bit regions are sequentially read. A data writing operation or a stored data reading operation of a memory track, e.g., a first memory track 10 selected from the first to third memory tracks 10, 30, and 50 of the magnetic memory device will be described below with reference to FIGS. 3A through 3C, and 4A and 4B. Here, a case where the data storage region 71 of the memory track includes six data bit regions will be described.

FIGS. 3A through 3C are views illustrating a data writing operation performed on a selected memory track of a magnetic memory device according to an embodiment of the present invention; FIGS. 4A and 4B are views illustrating a stored data reading operation performed on a selected memory track of a magnetic memory device according to an embodiment of the present invention; and FIG. 5 is a schematic graph illustrating a magnetic domain motion signal: Pulse 1 (motion), a reading pulse signal : Pulse 2 (reading) and a writing switching current signal : Pulse 2 (writing) that are applied to a magnetic memory device according to an embodiment of the present invention. In FIG. 5, the horizontal axis is a time axis t.

The data writing operation is performed in the following manner. When a switching current is applied to a third data bit region D3 of the first memory track 10 selected as illustrated in FIG. 3A, a magnetization direction of the third data bit region D3 is reversed as illustrated in FIG. 3B. After that, when the magnetic domain motion current is applied to the first memory track 10, magnetization directions of respective data bit regions are moved to adjoining data bit regions, respectively, as illustrated in FIG. 3C. That is, magnetization directions of first to sixth data bit regions D1, D2, D3, D4, D5, and D6 of the data storage region 71 illustrated in FIG. 3B are respectively moved one data bit region across to the second to sixth data bit regions D2, D3, D4, D5, D6 and a first data bit region B1 of an adjoining buffer region 75 as illustrated in FIG. 3C.

As described above, the magnetization direction of the predetermined data bit region 11 is defined, and data (magnetization direction) of the predetermined data bit region 11 is moved to an adjoining data bit region, i.e., a fourth data bit region D4 after a predetermined time elapses, and a writing signal is again input to the predetermined data bit region 11 to again define a magnetization direction. Using the magnetic domain motion current periodically applied and the writing switching current periodically applied in synchronization with the magnetic domain motion current illustrated in FIG. 5, such defining a magnetization direction and the motion process are alternately performed, so that a plurality of data bits are recorded in an array on the plurality of data bit regions of the first memory track 10. After the data recording operation is completed, a data storage position may be maintained or a motion signal moving the magnetic domains in the opposite direction is input, so that data stored can be maintained on the first to sixth data bit regions D1, D2, D3, D4, D5, and D6 of the data storage region 71.

The stored data reading operation is performed in the following manner. Referring to FIG. 4A, a reading pulse current is applied to the third data bit region D3 so that data of the third data bit region D3 is read. After that, when the magnetic domain motion current is applied to the first memory track 10 as illustrated in FIG. 4B, magnetization directions of respective data bit regions are moved to adjoining data bit regions, respectively. That is, magnetization directions of the first to sixth data bit regions D1, D2, D3, D4, D5, and D6 of the data storage region 71 illustrated in FIG. 4A. are moved, by one data bit region, to the second to sixth data bit regions D2, D3, D4, D5, D6 and the first data bit region B1 of the adjoining buffer region 75, respectively, as illustrated in FIG. 4B.

As described above, the magnetization direction of the predetermined data bit region 11 is read, and data (magnetization direction) of the predetermined data bit region 11 is moved to the adjoining data bit region, i.e., a fourth data bit region D4 after a predetermined time elapses, and a reading signal is again input to the predetermined data bit region 11 to perform a data reading operation. Using the magnetic domain motion current periodically applied and the reading pulse current periodically applied in synchronization with the magnetic domain motion current illustrated in FIG. 5, such reading of a magnetization direction and the motion process are alternately performed until reading of a predetermined plurality of data bits stored on the first memory track 10 is completed. After the data reading operation is completed, a data storage position may be maintained or a motion signal moving the magnetic domains in the opposite direction may be input, so that data originally stored on the first to sixth data bit regions D1, D2, D3, D4, D5, and D6 of the data storage region 71 is returned to the first to sixth data bit regions D1, D2, D3, D4, D5, and D6, respectively, and maintained there.

Here, a data writing or reading operation for the second and third memory tracks 30 and 50 may be performed as illustrated in FIGS. 3A through 3C, and FIGS. 4A and 4B.

During the reading operation, the reading pulse current is periodically applied in synchronization with a domain motion signal without polarity reversion as illustrated in FIG. 5. An amount of current flowing through a tunnel barrier, and a resistance therefrom when the reading pulse current is applied to the reference layer 19 and predetermined data bit regions 11, 31, and 51 of the first to third memory tracks 10, 30, and 50, differ depending on whether magnetization directions of the predetermined data bit regions are parallel to or anti-parallel to a magnetization direction of the reference layer 19. For example, when the magnetization directions of the predetermined data bit regions 11, 31, and 51 of the first to third memory tracks 10, 30, and 50 are parallel to the reference layer 19, resistance of a corresponding tunnel barrier is smaller than when the magnetization directions of the predetermined data bit regions 11, 31, and 51 are anti-parallel to the reference layer 19. Data stored in the predetermined data bit regions 11, 31, and 51 is read using such a resistance difference.

In the above descriptions, though a magnetic domain motion is performed in units of one data bit region, and the magnetic domain motion and the data bit writing or reading operation are alternatively performed, those descriptions are provided for an exemplary purpose only and various modifications may be possible. For example, after a plurality of data bit regions are moved, the writing or reading operation may be performed.

Also, in the above descriptions, the magnetic memory device according to the present invention can incorporate a magnetic device capable of reading a plurality of data bits (i.e., an MTJ or GMR sensor) and a recording magnetic device using spin transfer torque into a single device, but the present invention is not limited to this particular embodiment. That is, the magnetic memory device according to the present invention may be used as a magnetic device (i.e., an MTJ or GMR sensor) capable of reading a plurality of data bits using a magnetic domain motion, or may be also used as a recording magnetic device using spin transfer torque, capable of recording a plurality of data bits using the magnetic domain motion.

Also, in the above descriptions, the magnetic memory device according to the present invention performs a data writing operation using the spin transfer torque by directly applying a writing current signal to an MTJ cell consisting of the reference layer 19, the predetermined data bit regions 11, 31, and 51 of the first to third memory tracks 10, 30, and 50 that are located on the reference layer 19, and the non-magnetic layer 17 interposed therebetween, but the present invention is not limited to this particular embodiment.

That is, in the magnetic memory device according to another embodiment of the present invention, a data bit may be recorded by selectively reversing a magnetization direction of a magnetic domain of a predetermined data bit region included in at least one memory track of first to third memory tracks 10, 30 and 50 using a magnetic field induced by a current. In this case, the magnetic memory device according to the current embodiment of the present invention may include a structure generating a magnetic field for selectively reversing a magnetization direction of the predetermined data bit region of the memory track, and a FET for reading data stored in the memory track, instead of the second input portion 86 directly applying a writing or reading current signal to the memory track.

Also, in the above descriptions, the magnetic memory device according to previous embodiments the present invention has a multi-stacked structure of the first to third memory tracks 10, 30, and 50, but those descriptions are provided for an exemplary purpose only, and the number of memory tracks formed in a multi-stack may change.

As described above, in the magnetic memory device of the present invention, a plurality of magnetic domains may be provided, so that data bits can be stored in an array. Also, since a memory track using a magnetic domain motion is provided and the memory track is formed in a multi-stack, data storage capacity may increase.

Also, since the selecting part selecting a memory track on which a reading or writing operation is to be performed is realized using the shared transistor, the structure of the selecting part can be simplified even more.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A magnetic memory device comprising:
a plurality of memory tracks (10, 30, 50) stacked on a substrate to form multi-stack, each having a plurality of magnetic domains formed so that data bits, each consisting of a magnetic domain, are stored in an array;
a plurality of bit lines (20, 40, 60) formed close to respective memory tracks;
a connector (15, 35, 55) formed between each memory track and each bit line to constitute an magnetic tunnel junction (MTJ) cell together with one data bit region of each memory track;
a first input portion (80) electrically connected to each memory track and inputting a magnetic domain motion signal to move data stored in a data bit region of the memory track to an adjoining data bit region; and
a selecting part (90) selecting a memory track on which a reading or writing operation is to be performed from the plurality of memory tracks.

2. The memory device of claim 1, wherein the connector comprises a reference layer (19) formed to correspond to a portion of the memory track and having a pinned magnetization direction,
wherein a data bit corresponding to an effective size of the reference layer is stored in an array on the memory track.

3. The memory device of claim 2, wherein the connector further comprises a non-magnetic layer (17) interposed between the reference layer (19) and the memory track (10, 30, 50).

4. The memory device of claim 3, wherein the non-magnetic layer (17) is a conduction layer or an insulation layer acting as a tunnel barrier.

5. The memory device of any preceding claim, wherein the selecting part comprises:
a plurality of impurity regions (91, 93, 95) respectively connected to data bit regions constituting MTJ cells of the memory tracks; and
a gate (G1, G2, G3) formed between two impurity regions,
wherein the selecting part (90) has a shared transistor structure where at least one impurity region serves as a drain for a predetermined memory track and serves as a source for another memory track, and
each of the impurity regions (91, 93, 95) is connected to the data bit region constituting the MTJ of each memory track via a conductive plug (86, 87, 88).

6. The memory device of any preceding claim, wherein each memory track comprises:
a data storage region (71) having data bit regions corresponding to the number of data bits to be stored and storing a plurality of data bits; and
a buffer region (75) that adjoins the data storage region and storing, if necessary, data moved to outside of the data storage region during a magnetic domain motion.

7. The memory device of claim 6, wherein each memory track comprises a plurality of data storage regions,
wherein the buffer region (75) is located between consecutive data storage regions (71), and each connector and selecting parts are formed to correspond to a corresponding data storage region of the plurality of data storage regions formed on each memory track.

8. The memory device of any preceding claim, further comprising a second input portion (85) inputting at least one of a writing signal and a reading signal to the MTJ cell via the bit line.

## Patentansprüche

1. Magnetspeichervorrichtung, umfassend:
eine Mehrzahl von Speicherbahnen (10, 30, 50), die auf einem Substrat derart aufgeschichtet sind, dass sie einen Multistapel bilden, und die jeweils eine Mehrzahl von magnetischen Domänen aufweisen, die derart ausgebildet sind, dass Datenbits, die jeweils aus einer magnetischen Domäne bestehen, in einem Feld gespeichert sind,
eine Mehrzahl von Bitleitungen (20, 40, 60), die nahe den zugehörigen Speicherbahnen ausgebildet sind,
ein Verbindungselement (15, 35, 55), das zwischen jeder Speicherbahn und jeder Bitleitung derart ausgebildet ist, dass eine Magnettunnelübergangs(MTJ)-Zelle zusammen mit einer Datenbitregion einer jeweiligen Speicherbahn gebildet ist,
einen ersten Eingabeabschnitt (80), der mit jeder Speicherbahn elektrisch verbunden ist und der ein Bewegungssignal der magnetischen Domäne derart eingibt, dass in einer Datenbitregion der Speicherbahn gespeicherte Daten zu einer angrenzenden Datenbitregion verschoben werden, und
einen Auswahlteil (90) zum Auswählen einer Speicherbahn, für die eine Lese- oder Schreiboperation auszuführen ist, aus der Mehrzahl von Speicherbahnen.

2. Magnetspeichervorrichtung nach Anspruch 1, wobei das Verbindungselement eine Referenzschicht (19) umfasst, die derart ausgebildet ist, dass sie einem Abschnitt der Speicherbahn entspricht und die eine gepinnte Magnetisierungsrichtung aufweist,
wobei ein Datenbit, das einer effektiven Größe der Referenzschicht entspricht, in einem Feld der Speicherbahn gespeichert ist.

3. Magnetspeichervorrichtung nach Anspruch 2, wobei das Verbindungselement weiter eine nichtmagnetische Schicht (17) umfasst, die zwischen die Referenzschicht (19) und die Speicherbahn (10, 30, 50) eingesetzt ist.

4. Magnetspeichervorrichtung nach Anspruch 3, wobei die nichtmagnetische Schicht (17) eine Leiterschicht oder eine Isolierschicht ist, die als Tunnelbarriere dient.

5. Magnetspeichervorrichtung nach einem der vorhergehenden Ansprüche, wobei der Auswahlteil umfasst:
eine Mehrzahl von Fremdstoffregionen (91, 93, 95), die mit zugehörigen Datenbitregionen verbunden sind, die MTJ-Zellen der Speicherbahnen bilden, und
ein Gate (G1, G2, G3), das zwischen zwei Fremdstoffregionen ausgebildet ist,
wobei der Auswahlteil (90) eine gemeinsame Transistorstruktur aufweist, bei der mindestens eine Fremdstoffregion als Drain für eine vorgegebene Speicherbahn dient und als Source für eine andere Speicherbahn dient, und
jede der Fremdstoffregionen (91, 93, 95) über einen leitfähigen Stift (86, 87, 88) mit der Datenbitregion verbunden ist, die die MTJ jeder Speicherbahn bildet.

6. Magnetspeichervorrichtung nach einem der vorhergehenden Ansprüche, wobei jede Speicherbahn umfasst:
eine Datenspeicherregion (71), die Datenbitregionen aufweist, die der Anzahl an Datenbits entsprechen, die zu speichern sind, und die eine Mehrzahl von Datenbits speichern, und
eine Pufferregion (75), die sich an die Datenspeicherregion anschließt und die, wenn nötig, Daten speichert, die bei einer Bewegung einer magnetischen Domäne aus der Datenspeicherregion verschoben wurden.

7. Magnetspeichervorrichtung nach Anspruch 6, wobei jede Speicherbahn eine Mehrzahl von Datenspeicherregionen umfasst,
wobei die Pufferregion (75) zwischen aufeinanderfolgenden Datenspeicherregionen (71) gelegen ist und jedes Verbindungselement und Auswahlteile derart ausgebildet sind, dass sie einer zugehörigen Datenspeicherregion der Mehrzahl von Datenspeicherregionen entsprechen, die auf jeder Speicherbahn ausgebildet sind.

8. Magnetspeichervorrichtung nach einem der vorhergehenden Ansprüche, weiter umfassend einen zweiten Eingabeabschnitt (85), der über die Bitleitung ein Schreibsignal und/oder ein Lesesignal an die MTJ-Zelle eingibt.

## Revendications

1. Dispositif de mémoire magnétique comportant :
une pluralité de pistes de mémoire (10, 30, 50) empilées sur un substrat pour former une multi pile, chacune ayant une pluralité de domaines magnétiques réalisés de façon que des bits de donnée, chacun consistant en un domaine magnétique, soient stockés dans une matrice ;
une pluralité de lignes de bit (20, 40, 60) formées près des pistes de mémoire respectives ;
un connecteur (15, 35, 55) formé entre chaque piste de mémoire et chaque ligne de bit pour constituer une cellule de jonction à effet tunnel magnétique (Magnetic Tunnel Junction MTJ) ensemble avec une zone de bit de donnée de chaque piste de mémoire ;
une première partie d'entrée (80) électriquement connectée à chaque piste de mémoire et injectant un signal de mouvement de domaine magnétique pour déplacer les données stockées dans une zone de bit de donnée de la piste de mémoire vers une zone de bit de donnée contiguë et
une partie de sélection (90) sélectionnant une piste de mémoire sur laquelle une opération de lecture ou d'écriture doit être accomplie parmi les pistes de mémoire de la pluralité.

2. Dispositif de mémoire selon la revendication 1, dans lequel le connecteur comporte une couche de référence (19) formée pour correspondre à une partie de la piste de mémoire et ayant une direction de magnétisation marquée,
dans lequel un bit de données correspondant à une taille effective de la couche de référence est stockée dans une matrice sur la piste de mémoire.

3. Dispositif de mémoire selon la revendication 2, dans lequel le connecteur comporte en outre une couche non magnétique (17) interposée entre la couche de référence (19) et la piste de mémoire (10, 30, 50).

4. Dispositif de mémoire selon la revendication 3, dans lequel la couche non magnétique (17) est une couche conductrice ou une couche isolante travaillant comme une barrière à effet tunnel.

5. Dispositif de mémoire selon l'une des revendications précédentes,
dans lequel la partie de sélection comporte :
une pluralité de zones d'impuretés (91, 93, 95) connectées respectivement à des zones de bits de données constituant les cellules MTJ des pistes de mémoire et
une porte (G1, G2, G3) formée entre les zones d'impuretés,
dans lequel la partie de sélection (90) à une structure de transistor partagée où au moins une zone d'impuretés sert de drain pour une piste de mémoire prédéterminée et sert de source pour une autre piste de mémoire et
chacune des zones d'impuretés (91, 93, 95) est connectée à la zone de bits de données constituant la MTJ de chacune des pistes de mémoire à travers une fiche conductrice (86, 87, 88).

6. Dispositif de mémoire selon l'une des revendications précédentes,
dans lequel chaque piste de mémoire comprend :
une ayant des zones de bits de données correspondant au nombre de bits de données à stocker et stockant une pluralité de bits de données et
une zone tampon (75) accolée à la zone de stockage de données et stockant, si nécessaire, des données déplacées vers l'extérieur de la zone de stockage de données pendant un mouvement de domaine magnétique.

7. Dispositif de mémoire selon la revendication 6, dans lequel chaque piste de mémoire comprend une pluralité de zone de stockage de données
dans lequel la zone tampon (75) est située entre des zones de stockage de données (71) consécutives et chaque connecteur et parties de sélection est formé pour correspondre à une zone de stockage de données correspondante de la pluralité de zone de stockage de données formées sur chaque piste de mémoire.

8. Dispositif de mémoire selon l'une des revendications précédentes, comportant en outre une seconde partie d'entrée (85) injectant au moins un signal d'écriture et un signal de lecture dans la MTJ à travers la ligne de bits.
